# EUROPEAN PATENT SPECIFICATION

(11) **EP 3 757 521 B1**
(45) Date of publication and mention of the grant of the patent: **16.10.2024**
(21) Application number: 19182747.6
(22) Date of filing: 26.06.2019
(51) Int. Cl.: G01D 5/25

(54) **PNEUMATIC POSITION SENSOR**
PNEUMATISCHER POSITIONSSENSOR
CAPTEUR DE POSITION PNEUMATIQUE

(43) Date of publication of application: 30.12.2020
(73) Proprietor: Dafine Engineering OÜ, 11317 Tallinn (EE)
(72) Inventor: Vasko, Veiko, 11317 Tallinn (EE); Pruul, Rando, 11317 Tallinn (EE)
(74) Representative: AAA Patendibüroo OÜ

(56) References cited:
- DE-A1- 102016 217 563
- DE-U1- 202011 101 232
- US-A1- 2004 250 678

## Description

### TECHNICAL FIELD

The present invention relates generally to position sensors that are operated pneumatically, e.g., by compressed air, and in particular, to pneumatic sensors used in test adapters for testing plugs of wire harnesses for checking the existence and correct positioning of components in such plugs.

### BACKGROUND ART

Wire harnesses assembly has long been a labor intensive exercise. So is testing such wire harnesses. Testing adapters are used for connecting plugs of wire harnesses to the testing equipment. Besides electrical connections, often other tests and verifications are required, such as presence and position test of components. Since commonly in these test systems compressed air is used also for pneumatic retainers and sealing verification, it is feasible to use compressed air to operate position sensors in such test adapters.

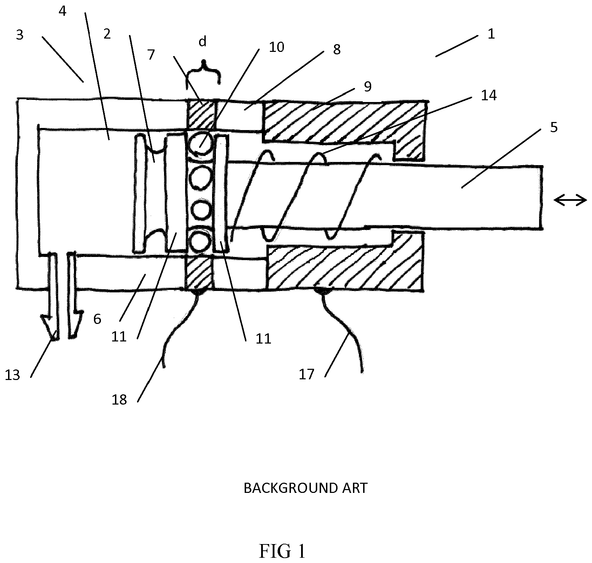

Known is a pneumatic position sensor by Feinmetall GmbH, shown in Fig 1. The pneumatic position sensor 1 comprises a metal piston 2 in a cylindrical housing 3 comprising a cylindrical void 4 in it, said metal piston 2 having a shaft 5, extending out from said housing 3. The housing 3 is made of several pieces, having a plastic portion 6 in one end, a conductive ring 7, an isolating ring 8, and a metal end cap 9. The piston 2 and the shaft 5 are electrically connected. In the depicted position of the piston 2 in said housing 3 it is mechanically and electrically connected to the conductive ring 7. The conductive ring 7 has width d, defining the contact range. The electrical connection between the piston 2 and the conductive ring 7 is provided through a plurality of metal balls 10 attached to and surrounding the shaft 5. The metal balls 10 are hold in place by two plates 11 on each side of the balls 10, perpendicular to the shaft 5. In said depicted position of the piston 2, when the metal balls 10 are in contact with the conductive ring 7, the shaft 5 is extending through the metal end cap 9 of the housing to contact distance. In any alternative position of the piston 5 the metal balls 10 are mechanically connected with either the isolating ring 8 or plastic portion 6, thus not electrically connected to the conductive ring 7. In a second position of the piston the shaft is extending through the metal portion of the housing to a second distance. The shaft is electrically connected with said metal portion of the housing. The conductive ring 7 and the metal end cap 9 have electrical leads 17, 18 connected to it so the current circuit is closed when the piston is in a position with the surface of the metal balls in electrical contact with the conductive ring, and the current circuit is open when the piston is in contact with plastic portion 6 of the housing or with the isolating ring 7. An air inlet 13 is connected to said plastic portion 6 of the housing for receiving pressured air to provide movement to the piston. A spring 14 is on said shaft 5 to return the piston back to the start position.

Such pneumatic position sensor can be used in test adapters to verify presence and position of accessories housing covers, attachment clips, strain reliefs, secondary locking, CPA (connector position assurance). The pneumatic position sensor is operated by compressed air and the change of the status of the position sensor from closed circuit to open circuit may indicate, e.g., the presence and proper position of a certain mechanical component in the plug while the change from closed circuit to open circuit to close circuit may indicate, e.g., a missing component, or improper positioning of said component.

Such pneumatic position sensors must be as small as possible, e.g., 14mm in length and 6mm in diameter to avoid the need to drastically increase the size and complexity of test adapter. The nature of their operation means they consist of several components in a very limited space. It makes the manufacturing and assembly of such sensors very challenging and thus, leading to expensive products as well as to possibility of failure.

What is needed, therefore, is a new pneumatic position sensor that is easier to manufacture and is made up of smaller number of parts.

### DISCLOSURE OF INVENTION

The goal of the invention is achieved by a pneumatic position sensor 1 according to claim 1.

Preferably, the housing is made of a single piece as in claim 2.

Preferably, the housing is keyhole-shaped as in claim 3. This shape allows easily and securely fix the pneumatic position sensor in a test adapter for verification of presence and correct position of a mechanical object being tested and provides available space to fit internal mechanics and circuits without claiming additional space from test adapter.

Another aspect of the invention is a test adapter, comprising the pneumatic position sensor according to the present invention.

### BRIEF DESCRIPTION OF DRAWINGS, R42(1)(d)

Embodiments of the present invention will now be described, by way of example, with reference to the accompanying drawings in which:
Fig 1 is a pneumatic position sensor known from a background art.
Fig 2 is a pneumatic position sensor according to one embodiment of the invention, wherein Fig 2A is a side view with the sliding piston in one position and Fig 2D is a side view with the sliding piston in another position, Fig 2B is a front view of the sensor, and Figs 2C and 2E are cutoff views of Fig 2A and 2D correspondingly along the line B-B on Fig 2B.
Fig 3A and 3B are test adapters comprising the pneumatic position sensor according to one embodiment of the invention.

### EXAMPLES FOR CARRYING OUT THE INVENTION

Fig 1 is a pneumatic position sensor known from a background art as explained in background part of the document.

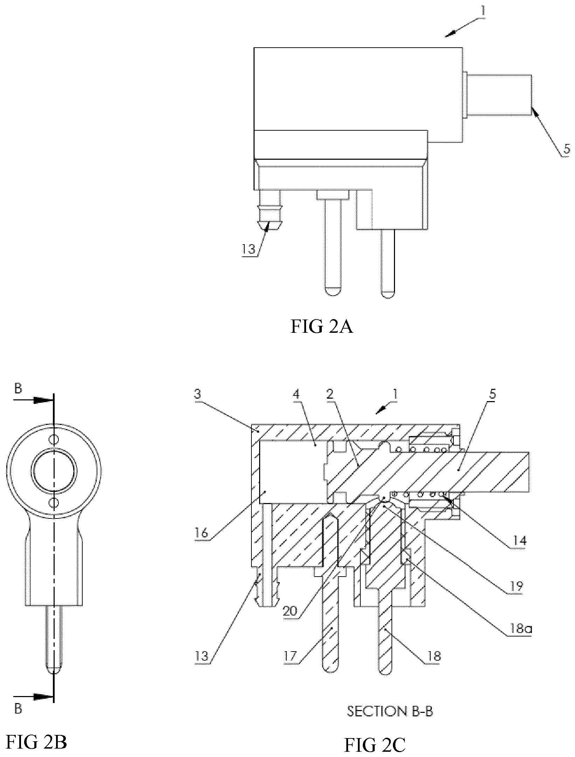

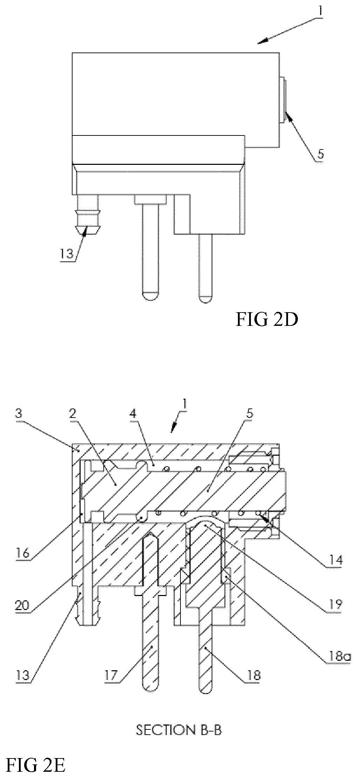

Fig 2A to 2E is a pneumatic position sensor according to one embodiment of the invention. A pneumatic position sensor 1 comprises of a one piece metal housing 3, having keyhole shape. Said housing has a cylindrical void 4 in it, having an air inlet 13 in connection with a first end 16 of said void 4 in a first end of said housing 3, a metal sliding piston 2 with shaft 5 in said cylindrical void 4, said shaft 5 extending out of said housing 3 from a second end of said housing 3, said sliding piston 2 arranged to move from a first position (see Fig 2A and 2C) to a second position (see Fig 2D and 2E) when a pressurized air is applied through said air inlet 13 and with a spring 14 on said shaft 5 to return said sliding piston 2 from said second position back to said first position; said housing 3 comprising a pair of electrodes 17 and 18, wherein a first electrode 17 is electrically connected with said shaft 5 through said housing 3 and a second electrode 18 is connected to a means for contacting 20 said piston 2 in said first position and is disconnected from said piston 2 in said second position. Said second electrode 18 is extending through a wall of said housing 3 into said void 4, insulated electrically from housing 3 by a bushing 18a, wherein said second contact 18 having ball tip 19 and the sliding piston has means 20 for electrically contacting said ball tip 19.

Such sensor housing is preferably made from a single piece of metal, which gives it more rigidity and reduces or eliminates risks of air leaks and also reduces the likelihood of air port breakage. Such sensor can have other shapes than keyhole shape (e.g., circular, oval, rectangular, etc), but the keyhole shape is preferable as it provides alternative fixing strategies for keeping the sensor in place. The single piece housing also means less components that results in lesser cost and longer life. All load bearing parts are preferably made of metal that also results in longer life and reduced cost.

The solder pins make it possible to replace wires by soldering; larger cross section wires can be used for more robust and reliable construction.

The sensor is preferably used in test adapters, but it can also used for other purposes, e.g., as a single wire pneumatically activated electrical contact.

The housing can be made of any conductive material, e.g., any conductive metal or compound or alloy, such as copper, gold, silver, their compounds or their alloys. Any suitable technology known from the art can be used for manufacturing the housing, including suitable surface treatment methods. The housing can be preferably made using CNC milling, but it can also be cast as a single part or 3D printed. The piston is single part preferably made by turning. The ball tip contact is off the shelf product provided by multiple suppliers.

Besides o-ring, only one other plastic part is used (insulating sleeve between housing and ball-tip contact).

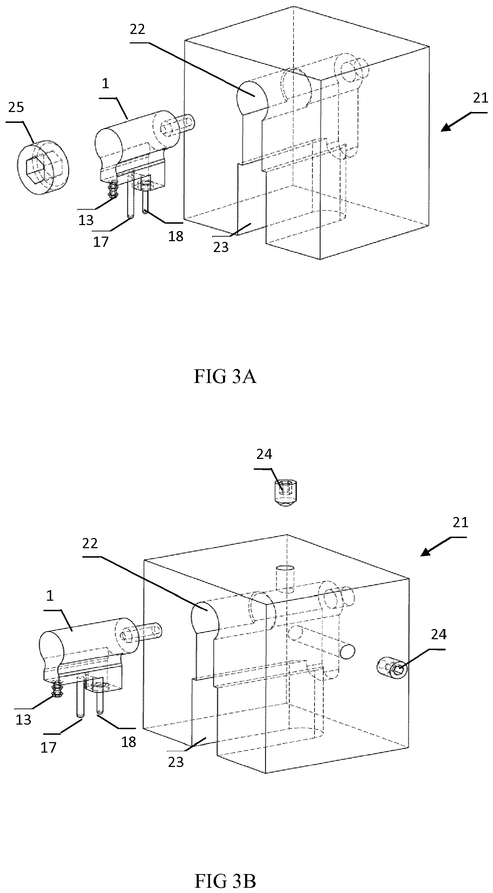

Such sensor can be less than 10mm in length and less than 6mm in diameter, so it can be well fitted into test adapter for wire harnesses. In such test adapter 21, shown in Fig 3A and 3B, the sensor pocket 22 geometry contains access groove 23 for wires, connected to the electrodes 17 and 18, and a pneumatic hose, connected to the air inlet 13, the keyhole shape of the housing is preferable over cylindrical housing, making it easier to fix the sensor in place, e.g., with screws 24 (see Fig 3B), since the sensor has more hard material surface and no gaps or cracks in the body. Alternatively, cap 25 (Fig 3A) can be used to fix the sensor in said test adapter. Since housing body is preferably CNC machined, custom shapes with side screw holes or threaded mounting points can be easily designed and manufactured. Multi piston sensors can be also made for custom applications.

## Claims

1. A pneumatic position sensor (1), comprising:
a housing (3), comprising at least one cylindrical void (4) in it, having an air inlet (13) in connection with a first end (16) of said void (4) in a first end of said housing (3);
a sliding piston (2) with shaft (5) in said cylindrical void (4), said shaft (5) extending out of said housing (3) from a second end of said housing (3), said sliding piston (2) arranged to move from a start position when a pressurized air is applied through said air inlet (13) and with a spring (14) on said shaft (5) to return said sliding piston (2) from said second position back to said start position;
said housing (3) comprising a pair of electrodes (17, 18), wherein a first electrode (17) is electrically connected with said shaft (5) through said housing (3) and a second electrode (18) insulated from said housing (3) by a bushing (18a) is connected to a means for contacting (20) said piston (2) in said first position and is disconnected from said piston (2) in said second position
**characterized in that**
said second electrode (18) is extending through a wall of said housing (3) into said void (4), wherein said second electrode (18) having rounded (19) tip and the sliding piston has means (20) for electrically contacting said rounded tip (19).

2. A sensor according to claim 1, wherein said housing (3) is made as a single piece.

3. A sensor according to claims 1 to 2, wherein said housing (3) has keyhole shape.

4. A test adapter (21) for connecting with a plug for wire harnesses, comprising said pneumatic position sensor (1) according to claims 1 to 3.

## Patentansprüche

1. Pneumatischer Positionssensor (1), umfassend:
ein Gehäuse (3), umfassend mindestens einen zylindrischen Hohlraum (4) darin, mit einem Lufteinlass (13) in Verbindung mit einem ersten Ende (16) des Hohlraums (4) in einem ersten Ende des Gehäuses (3). ;
einen Gleitkolben (2) mit Welle (5) in dem zylindrischen Hohlraum (4), wobei sich die Welle (5) aus dem Gehäuse (3) von einem zweiten Ende des Gehäuses (3) aus erstreckt, wobei der Gleitkolben (2) angeordnet ist um sich aus einer Startposition zu bewegen, wenn Druckluft durch den Lufteinlass (13) zugeführt wird, und um mit einer Feder (14) auf der Welle (5) den Gleitkolben (2) aus der zweiten Position zurück in die Startposition zu bringen;
wobei das Gehäuse (3) ein Paar Elektroden (17, 18) umfasst, wobei eine erste Elektrode (17) elektrisch mit der Welle (5) durch das Gehäuse (3) verbunden ist und eine zweite Elektrode (18) von dem Gehäuse isoliert ist ( 3) durch eine Buchse (18a), die mit einem Mittel zum Kontaktieren (20) des Kolbens (2) in der ersten Position verbunden ist und von dem Kolben (2) in der zweiten Position getrennt ist
**dadurch gekennzeichnet**
die zweite Elektrode (18) sich durch eine Wand des Gehäuses (3) in den Hohlraum (4) erstreckt,
wobei die zweite Elektrode (18) eine abgerundete (19) Spitze hat und der Gleitkolben Mittel (20) zum elektrischen Kontaktieren derselben hat abgerundete Spitze (19).

2. Sensor nach Anspruch 1, **dadurch gekennzeichnet, dass** das Gehäuse (3) einstückig ausgebildet ist.

3. Sensor nach den Ansprüchen 1 bis 2, wobei das Gehäuse (3) Schlüssellochform hat.

4. Prüfadapter (21) zum Verbinden mit einem Stecker für Kabelbäume, umfassend den pneumatischen Positionssensor (1) nach den Ansprüchen 1 bis 3.

## Revendications

1. Capteur de position pneumatique (1), comprenant :
un logement (3), comprenant au moins un vide cylindrique (4) en lui, ayant une entrée d'air (13) en connexion avec une première extrémité (16) dudit vide (4) dans une première extrémité dudit logement (3) ;
un piston coulissant (2) avec un arbre (5) dans ledit vide cylindrique (4), ledit arbre (5) s'étendant hors dudit boîtier (3) à partir d'une seconde extrémité dudit boîtier (3), ledit piston coulissant (2) étant agencé pour se déplacer depuis une position de départ lorsqu'un air sous pression est appliqué à travers ladite entrée d'air (13) et avec un ressort (14) sur ledit arbre (5) pour ramener ledit piston coulissant (2) de ladite deuxième position vers ladite position de départ ;
ledit boîtier (3) comprenant une paire d'électrodes (17, 18), dans lequel une première électrode (17) est connectée électriquement audit arbre (5) à travers ledit boîtier (3) et une seconde électrode (18) isolée dudit boîtier ( 3) par une douille (18a) est relié à un moyen pour contacter (20) ledit piston (2) dans ladite première position et est déconnecté dudit piston (2) dans ladite deuxième position **caractérisé en ce que**
ladite deuxième électrode (18) s'étend à travers une paroi dudit boîtier (3) dans ledit vide (4), dans lequel ladite deuxième électrode (18) ayant une pointe arrondie (19) et le piston coulissant a des moyens (20) pour contacter électriquement ledit pointe arrondie (19).

2. Capteur selon la revendication 1, dans lequel ledit boîtier (3) est réalisé en une seule pièce.

3. Capteur selon les revendications 1 à 2, dans lequel ledit boîtier (3) a une forme en trou de serrure.

4. Adaptateur de test (21) pour connexion avec une fiche pour faisceaux de câbles, comprenant ledit capteur de position pneumatique (1) selon les revendications 1 à 3.
